(19) Europäisches Patentamt / European Patent Office / Office européen des brevets

(11) **EP 3 564 626 B1**

(12) **FASCICULE DE BREVET EUROPEEN**

(45) Date de publication et mention de la délivrance du brevet:
**02.12.2020 Bulletin 2020/49**

(21) Numéro de dépôt: **19165343.5**

(22) Date de dépôt: **26.03.2019**

(51) Int Cl.:
*G01D 3/02* (2006.01)    *G06F 3/041* (2006.01)
*G06F 3/046* (2006.01)

(54) **PROCÉDÉ D'INITIALISATION D'UN RÉSEAU DE CAPTEURS**

INITIALISIERUNGSVERFAHREN EINES SENSORNETZES

METHOD OF INITIALISING A SENSOR NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.03.2018 FR 1852637**

(43) Date de publication de la demande:
**06.11.2019 Bulletin 2019/45**

(73) Titulaire: **Commissariat à l'Énergie Atomique et aux Énergies Alternatives 75015 Paris (FR)**

(72) Inventeur: **LEIRENS, Sylvain 38054 GRENOBLE cedex 09 (FR)**

(74) Mandataire: **Colombo, Michel Innovation Competence Group 310, avenue Berthelot 69372 Lyon Cedex 08 (FR)**

(56) Documents cités:
**US-A1- 2008 158 174    US-A1- 2011 172 738 US-A1- 2017 350 723**

**Description**

L'invention concerne un procédé d'initialisation d'un réseau de capteurs. L'invention concerne également un support d'enregistrement d'informations pour la mise en œuvre de ce procédé ainsi qu'un appareil implémentant ce procédé.

Un réseau de capteurs comporte typiquement au moins quatre capteurs, les capteurs étant reliés mécaniquement ensemble et étant configurés pour mesurer une même grandeur physique selon au moins deux axes non-colinéaires de mesure. Généralement, chacun de ces capteurs est également associé à au moins un coefficient de correction qui permet de corriger la mesure de ce capteur pour compenser des erreurs de mesure.

Lors de l'initialisation d'un tel réseau de capteurs, une première mesure de la grandeur physique réalisée par chacun des capteurs est acquise. Cette première mesure précède toutes les autres mesures acquises depuis la mise sous tension du réseau de capteurs. Idéalement, en présence d'une grandeur physique uniformément répartie sur l'ensemble des capteurs, les premières mesures devraient être identiques les unes aux autres. Dès lors, dans ce cas idéal, les écarts de mesures entre les différents capteurs sont essentiellement dus à des erreurs de mesure. Les coefficients de correction peuvent alors être réglés à partir de ces premières mesures pour que, après ce réglage, les écarts de mesure entre les différents capteurs soient presque nuls.

Par contre, si lors de l'initialisation du réseau de capteurs, à cause de la présence d'un perturbateur, la grandeur physique n'est pas uniforme, les écarts de mesures entre les différents capteurs ne sont pas nécessairement dus uniquement à des erreurs de mesure. Dans ce cas, les premières mesures ne doivent pas être utilisées pour régler les coefficients de correction. En effet, contrairement aux erreurs de mesure qui sont causées par des caractéristiques internes des capteurs, le perturbateur peut être déplacé ou modifié. Ainsi, suite à un déplacement du perturbateur, comme son retrait, les coefficients de correction réglés ne sont alors plus corrects et restent incorrects tant qu'une nouvelle initialisation du réseau de capteurs n'est pas déclenchée. Dans cet intervalle de temps, les mesures du réseau de capteurs ne sont plus fiables et l'utilisateur de ce réseau n'en est pas informé. Ainsi, il est souhaitable d'augmenter la fiabilité du procédé d'initialisation d'un réseau de capteur notamment vis-à-vis de la présence éventuelle d'un perturbateur.

De l'état de la technique est connu de US2008/158174A1 et US2017/350723A1. Le procédé d'initialisation décrit dans US2008/158174A1 concerne uniquement un réseau de capteurs mono-axes, c'est-à-dire un réseau dans lequel chaque capteur a un seul axe de mesure. Le procédé d'initialisation décrit dans US2017/350723A1 permet seulement de détecter la présence d'un magnétomètre tri-axe dont les mesures sont saturées.

L'invention vise à proposer un procédé d'initialisation plus fiable d'un réseau de capteurs dans lequel chaque capteur a au moins deux axes de mesure. Elle a donc pour objet un tel procédé d'initialisation d'un réseau de capteurs conforme à la revendication 1.

Les modes de réalisation de ce procédé de détection peuvent comporter une ou plusieurs des caractéristiques des revendications dépendantes.

L'invention a également pour objet un support d'enregistrement d'informations, lisible par un microprocesseur, qui comporte des instructions pour l'exécution du procédé objet de l'invention, lorsque ces instructions sont exécutées par le microprocesseur.

L'invention a également pour objet une unité de traitement pour la mise en œuvre du procédé objet de l'invention.

L'invention a également pour objet un système comportant l'unité de traitement objet de l'invention.

Les modes de réalisation de ce système peuvent présenter une ou plusieurs des caractéristiques des revendications dépendantes.

L'invention sera mieux comprise à la lecture de la description qui va suivre, donnée uniquement à titre d'exemple non limitatif et faite en se référant aux dessins sur lesquels :

- la figure 1 est une illustration schématique d'un système de relevé de la trace de la pointe d'un crayon sur un support d'écriture ;

- la figure 2 est une illustration schématique d'une partie d'un réseau de magnétomètres utilisé dans le système de la figure 1 ;

- la figure 3 est un graphe représentant les champs magnétiques mesurés par des magnétomètres du réseau de la figure 2 ;

- la figure 4 est un organigramme d'un procédé de relevé de la trace de la pointe d'un crayon sur un support d'écriture à l'aide du système de la figure 1, et

- la figure 5 est un organigramme d'une variante du procédé de la figure 4 qui n'est pas protégé.

Dans ces figures, les mêmes références sont utilisées pour désigner les mêmes éléments.

Chapitre I : Exemples de modes de réalisation

L'invention va maintenant être décrite dans le cas particulier d'un système de relevé de la trace de la pointe d'un crayon.

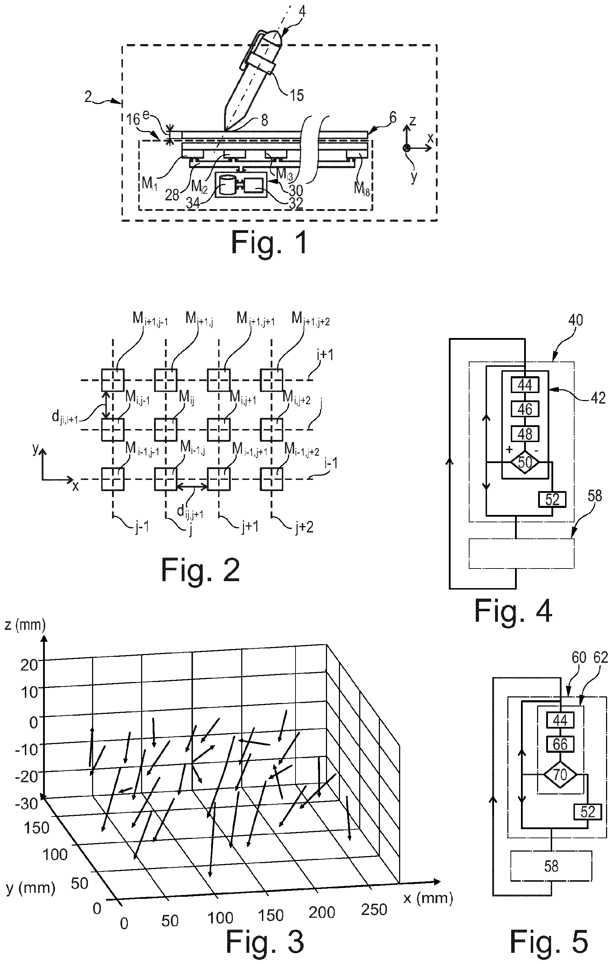

La figure 1 représente un tel système 2 de relevé de la trace de la pointe 8 d'un crayon 4 sur un support d'écriture 6. L'architecture d'un tel système a déjà été décrite, par exemple, dans le document WO2013144338A1. Par conséquent, par la suite, les informations contenues dans ce document ne sont pas reprises ici. Pour plus d'informations sur l'architecture de ce système connu, le lecteur peut consulter ce document WO2013144338A1.

Le système 2 comporte un appareil 16 de localisation de la pointe 8. Le crayon 4 est équipé d'un aimant permanent 15 fixé sans aucun degré de liberté au crayon 4.

L'appareil 16 permet de localiser l'aimant 15, et donc le crayon 4, dans un repère tridimensionnel XYZ. Par localisation, on entend ici la détermination de la position x, y, z de l'aimant 15 dans le repère XYZ et aussi la détermination de l'orientation du moment magnétique de l'aimant 15 par rapport aux directions X, Y et Z du repère XYZ.

A cet effet, l'appareil 16 comporte un réseau de N capteurs. Selon cet exemple de réalisation, chaque capteur est un magnétomètre tri-axes $M_{ij}$. Ainsi, dans ce mode de réalisation, la grandeur physique mesurée par chacun des capteurs est le champ magnétique. Typiquement, N est supérieur ou égal à quatre ou cinq et, de préférence, supérieur à seize ou trente-deux. Selon l'exemple de réalisation qui va être décrit, le nombre N de capteur est égal à trente-deux.

Chaque magnétomètre $M_{ij}$ est raccordé par l'intermédiaire d'un bus 28 de transmission d'informations à une unité électronique de traitement 30.

L'unité électronique de traitement 30 est capable de déterminer la position et l'orientation de l'aimant 15 et, à partir de ces informations, d'en déduire la position de la pointe 8 sur le support 6. A cet effet, l'unité électronique de traitement 30 comporte un microprocesseur 32 programmable apte à exécuter des instructions enregistrées sur un support d'enregistrement d'informations. L'unité électronique de traitement 30 comporte donc aussi une mémoire 34 contenant les instructions nécessaires pour l'exécution, par le microprocesseur 32, du procédé de la figure 4 ou 5.

La figure 2 représente une partie des magnétomètres $M_{ij}$ de l'appareil 16. A titre d'illustration, les magnétomètres $M_{ij}$ sont alignés en lignes et en colonnes pour former une matrice. Les indices i et j identifient, respectivement, la ligne et la colonne de cette matrice à l'intersection de laquelle se trouve le magnétomètre $M_{ij}$. Ici, pour fixer l'orientation des magnétomètres les uns par rapport aux autres, chaque magnétomètre $M_{ij}$ est fixé sans aucun degré de liberté aux autres magnétomètres.

Les centres de deux magnétomètres $M_{ij}$ et $M_{i,j+1}$ immédiatement consécutifs le long d'une ligne i sont séparés par une distance $d_{i,j,j+1}$. De façon similaire, le centre de deux magnétomètres $M_{ij}$ et $M_{i+1,j}$ immédiatement consécutifs le long d'une même colonne j sont séparés par une distance $d_{j,i,i+1}$. Ici, quelle que soit la ligne i, la distance $d_{ij,j+1}$ est la même. Cette distance est donc notée $d_j$. De façon similaire, quelle que soit la colonne j, la distance $d_{j,i,i+1}$ entre deux magnétomètres est la même. Cette distance est donc notée $d_i$. Dans ce mode de réalisation particulier, les distances $d_i$ et $d_j$ sont toutes les deux égales à d.

Typiquement, la distance d est comprise entre 1 et 4 cm notamment lorsque :

- la puissance de l'aimant permanent 15 est de 0,5 A.m$^2$,

- la sensibilité des magnétomètres $M_{ij}$ est de 4*10$^{-7}$T, et

- le nombre de magnétomètres $M_{ij}$ est de trente-deux.

La figure 3 représente dans le repère XYZ par trente-deux flèches les premières mesures du réseau de magnétomètres. Chaque flèche représente la direction du champ magnétique mesuré par un magnétomètre respectif $M_{ij}$. La longueur de chaque flèche représente l'intensité du champ magnétique mesuré par le magnétomètre correspondant.

Les premières mesures représentées sur la figure 3 ont été réalisées seulement en présence du champ magnétique terrestre. En particulier, lors de la réalisation de ces premières mesures, aucun objet magnétique, distinct de l'appareil 16, ne se situait à proximité des magnétomètres $M_{ij}$. Par « à proximité des magnétomètres $M_{ij}$ », on désigne une distance suffisamment courte, entre l'un des magnétomètres $M_{ij}$ et cet objet magnétique, pour modifier de façon non négligeable les mesures d'au moins l'un de ces magnétomètres $M_{ij}$. Par exemple, on considère ici que les mesures d'un magnétomètre $M_{ij}$ sont modifiées de façon non négligeable si la présence de l'objet magnétique fait varier l'intensité du champ magnétique mesuré par ce magnétomètres $M_{ij}$ d'au moins 1 % ou d'au moins 5 % par rapport à l'intensité du champ magnétique mesuré dans les mêmes conditions mais en absence de cet objet magnétique. Dans la suite, l'objet magnétique est appelé perturbateur.

Ainsi, on comprend que lors de la réalisation des mesures représentées sur la figure 3, l'aimant 15 n'est pas situé à proximité des magnétomètres $M_{ij}$.

Dans ces conditions, étant donné les faibles dimensions du réseau de magnétomètres $M_{ij}$ par rapport aux distances sur lesquelles le champ magnétique terrestre varie, il est admis que le champ magnétique terrestre, au niveau des magnétomètres $M_{ij}$, est uniforme. Par conséquent, en théorie, les champs magnétiques mesurés par les magnétomètres $M_{ij}$ devraient tous être identiques les uns aux autres. Toutefois, comme le montre clairement la figure 3, en pratique et avant qu'une correction appropriée soit appliquée, même lorsque le réseau de magnétomètres $M_{ij}$ est seulement en présence d'un champ magnétique uniforme sur toute sa surface, les champs magnétiques mesurés par les différents magnétomètres $M_{ij}$ ne sont pas identiques entre eux. Cela provient d'erreurs de mesure des magnétomètres $M_{ij}$. Une partie de ces erreurs de mesure peut provenir d'un défaut de reproductibilité du procédé de fabrication des magnétomètres. A cause de ce défaut de reproductibilité, les magnétomètres $M_{ij}$ ne sont pas strictement identiques les uns aux autres. Ces erreurs proviennent également du fait que chaque magnétomètre $M_{ij}$ comporte des pièces ferromagnétiques. Au cours de l'utilisation de ces magnétomètres $M_{ij}$, ces pièces ferromagnétiques ne sont pas toujours exposées au même champ magnétique, de sorte qu'il peut exister dans chacun des magnétomètres $M_{ij}$ des champs magnétiques rémanents qui ne sont pas identiques d'un magnétomètre $M_{ij}$ à un autre. Ces champs magnétiques rémanents décalent plus ou moins la mesure de chaque magnétomètre $M_{ij}$. Ce décalage est connu sous le terme anglais de « offset» et il décale en particulier l'amplitude du champ magnétique mesuré le long d'un axe de mesure. Par exemple, dans le cas des magnétomètres $M_{ij}$ de l'appareil 16, il a été observé que la distribution des offset des magnétomètres $M_{ij}$ est centrée entre 70 $\mu$T et 80 $\mu$T. Il a aussi était observé que quelques rares magnétomètres $M_{ij}$ présentent des offset supérieurs à 150 $\mu$T ou 500 $\mu$T.

Pour corriger ces erreurs de mesure, chaque magnétomètre $M_{ij}$ est associé à un ou plusieurs coefficients de correction. Ces coefficients de correction sont appliqués aux mesures non corrigées du magnétomètre $M_{ij}$ pour obtenir une mesure corrigée. Typiquement, la mesure non corrigée du magnétomètre $M_{ij}$ le long d'un axe de mesure est combinée, par addition et/ou multiplication, avec l'un de ces coefficients de correction pour obtenir la mesure corrigée le long de cet axe de mesure. Les valeurs de ces coefficients de correction sont réglées, lors d'une phase d'initialisation, de sorte que lorsque les magnétomètres $M_{ij}$ sont placés dans un champ magnétique uniforme, les mesures de tous ces magnétomètres $M_{ij}$ sont identiques à une marge de tolérance prédéterminée près. Par la suite, lorsque l'on parle de « mesure » sans préciser s'il s'agit de mesure corrigée ou non, c'est qu'il s'agit de la mesure corrigée.

Dans le mode de réalisation particulier décrit ici, chaque magnétomètre $M_{ij}$ est associé à trois coefficients de correction distincts, c'est-à-dire à un coefficient de correction par axe de mesure. La valeur de chacun de ces coefficients de correction est déterminée pour compenser l'offset de mesure le long d'un axe de mesure respectif. Ainsi, la mesure corrigée d'un magnétomètre $M_{ij}$ est obtenue en ajoutant à chaque mesure non corrigée sur un de ses axes de mesure, tel que l'un des axes X, Y, Z précédemment définis, le coefficient de correction associé à ce magnétomètre $M_{ij}$ et à cet axe particulier de mesure. Ici, les coefficients de correction associés à chaque magnétomètre $M_{ij}$ sont par exemple enregistrés dans la mémoire 34 et déterminés par l'unité 30 lors de la phase d'initialisation.

Pour déterminer les valeurs des coefficients de correction, il faut s'assurer que les premières mesures acquises des magnétomètres lors de cette phase d'initialisation ne sont pas perturbées par un perturbateur. En effet, dans ce dernier cas, il n'est pas possible d'initialiser correctement le réseau de magnétomètres et, en particulier, de déterminer les valeurs des coefficients de corrections à employer pour corriger les deuxièmes mesures suivantes. Or, comme l'illustre la figure 3, les premières mesures acquises lors de la phase d'initialisation présentent une grande dispersion même en absence de perturbateur ce qui rend très difficile la détection d'un perturbateur. Le procédé, mis en œuvre par le système 2, et qui va maintenant être décrit en référence au procédé de la figure 4, permet de remédier à cette difficulté.

Le procédé débute par une phase 40 d'initialisation du réseau de magnétomètres $M_{ij}$. Par exemple, la phase 40 est automatiquement déclenchée à chaque mise sous tension de l'appareil 16. Elle peut également être déclenchée à intervalle régulier ou en réponse à l'acquisition par l'unité 30 d'une commande particulière transmise, par exemple, par l'utilisateur.

La phase 40 débute par une étape 42 de détection automatique de la présence à proximité des magnétomètres $M_{ij}$ d'un perturbateur, c'est-à-dire d'un objet magnétique qui modifie de façon non uniforme le champ magnétique mesuré par les magnétomètres $M_{ij}$. Cette modification non uniforme du champ magnétique mesuré causée par la présence du perturbateur modifie les mesures réalisées par au moins un magnétomètre le long, généralement, de ses trois axes de mesures. Cela provoque donc en particulier une variation $\Delta V_1$ de l'amplitude mesurée par un premier magnétomètre $M_{ij}$ le long d'un premier axe de mesure. Cette modification provoque également une variation $\Delta V_2$ de l'amplitude mesurée par un second magnétomètre $M_{ij}$ le long de ce même premier axe de mesure. Le second magnétomètre est différent du premier magnétomètre. Chaque variation $\Delta V_1$ et $\Delta V_2$ représente la différence entre les amplitudes mesurées le long du premier axe de mesure en présence et en absence du perturbateur. Puisque le perturbateur modifie de façon non-uniforme le champ magnétique mesuré, il existe dans le réseau de magnétomètres $M_{ij}$ au moins deux magnétomètres pour lesquels l'écart entre les variations $\Delta V_1$ et $\Delta V_2$ est substantielle. Par exemple, l'écart est considéré comme étant substantiel si la condition suivante est vérifiée : $|\Delta V_1 - \Delta V_2| > \rho \times \text{Max}(|V_1|, |V_2|)$, où :

- le symbole «|...|» désigne la valeur absolue,

- le symbole « Max(..., ...) » désigne la fonction qui calcule le maximum des valeurs entre parenthèses,

- le symbole « x » désigne l'opération de multiplication,

- $V_1$ et $V_2$ désignent les amplitudes mesurées le long du premier axe de mesure, respectivement, par les premier et second magnétomètres,

- p est une constante supérieure à 0,01 et, de préférence, supérieure à 0,05 ou 0,1 ou 0,3 ou 0,5.

Ici, p est égal à 0,1 par exemple.

Lors de la phase 40 d'initialisation du réseau de magnétomètres, les premières mesures sont les mesures corrigées avec les valeurs des coefficients de correction déterminées lors d'une précédente exécution de la phase 40 ou avec des valeurs par défaut enregistrées dans la mémoire 34, par exemple lors de la fabrication de l'appareil 16. Les valeurs par défaut sont indépendantes des mesures réalisées par les magnétomètres $M_{ij}$. Par exemple, les valeurs par défaut des coefficients de correction sont utilisés s'il s'agit de la première exécution de la phase 40 ou suite à une commande de restauration des valeurs par défaut des coefficients de correction.

L'étape 42 débute par une opération 44 lors de laquelle les magnétomètres $M_{ij}$ mesurent chacun le champ magnétique actuellement présent. Lors de cette étape, l'unité électronique de traitement 30 acquiert ces premières mesures, puis, par exemple, les corrige en utilisant les précédentes valeurs des coefficients de correction enregistrées dans la mémoire 34. Puisque chaque magnétomètre $M_{ij}$ a trois axes de mesure, l'unité 30 acquière trois premières mesures pour chaque magnétomètre $M_{ij}$, c'est-à-dire une première mesure selon chacun des axes de mesure. Ces trois premières mesures d'un magnétomètre $M_{ij}$ forment un premier vecteur de mesure. Ici, ces premières mesures corrigées sont alors enregistrées dans une matrice A de dimension (n, p), où :

- n est le nombre de lignes et il est égal ici au nombre N de magnétomètres $M_{ij}$ du réseau, et

- p est le nombre d'axes de mesure de chaque magnétomètre $M_{ij}$ c'est-à-dire ici trois.

Chaque ligne k de la matrice A comporte les trois premières mesures acquises selon les trois axes de mesure d'un magnétomètre $M_{ij}$ particulier. Autrement dit, chaque ligne k comporte les trois composantes du premier vecteur de mesure de ce magnétomètre $M_{ij}$. Par la suite, un magnétomètre $M_{ij}$ particulier est désigné par la référence $M_k$. Ainsi, dans la suite de cette description, un magnétomètre particulier du réseau de l'appareil 16 peut aussi bien être désigné par la référence $M_{ij}$ que par la référence Mk. Ici, l'indice k est le numéro d'ordre de la ligne de la matrice A et il est donc compris entre 1 et N. Plus précisément, chaque ligne k comporte dans l'ordre :

- la mesure $MM_{k,x}$ de la projection orthogonale du champ magnétique mesuré par le magnétomètre $M_k$ sur l'axe de mesure parallèle à la direction X,

- la mesure $MM_{k,y}$ de la projection orthogonale du champ magnétique mesuré par le magnétomètre Mk sur l'axe de mesure parallèle à la direction Y, et

- la mesure $MM_{k,z}$ de la projection orthogonale du champ magnétique mesuré par le magnétomètre $M_k$ sur l'axe de mesure parallèle à la direction Z.

Les mesures $MM_{k,x}$, $MM_{k,y}$ et $MM_{k,z}$ présentent sur une même ligne k correspondent, respectivement, au trois composantes du premier vecteur de mesure du magnétomètre Mk.

Ici, les mesures acquises lors de l'opération 44 sont appelées « premières mesures » car elles correspondent aux premières mesures acquises après la mise sous tension de l'appareil 16 ou suite à une commande particulière, telle qu'une commande de réinitialisation des valeurs des coefficients de corrections. Ces premières mesures sont destinées à être utilisées ensuite pour régler les nouvelles valeurs des coefficients de corrections. Ainsi, ces premières mesures peuvent présenter une dispersion importante comme représenté sur la figure 3.

Les opérations suivantes de l'étape 42 sont exécutées par l'unité 30 et correspondent à l'exécution d'un test statistique sur les premières mesures.

Dans ce mode de réalisation, lors d'une opération 46, pour chaque axe de mesure, une valeur de référence pour l'amplitude du champ magnétique mesuré le long de cet axe est calculée. Plus précisément, lors de l'opération 46, ici, un champ magnétique moyen, noté $X_m$ par la suite, est calculé. Les composantes du champ magnétique moyen $X_m$

le long des directions X, Y et Z sont notées, respectivement, $X_{m,x}$ ; $X_{m,y}$ et $X_{m,z}$. Chaque composante $X_{m,x}$, $X_{m,y}$ et $X_{m,z}$ est une valeur moyenne des mesures, respectivement, $MM_{k,x}$, $MM_{k,y}$ et $MM_{k,z}$ pour k variant de 1 à N. Ainsi, la composante $X_{m,x}$ est calculée à l'aide de la relation suivante :

$$X_{m,x} = \frac{1}{N}\left(\sum_{k=1}^{k=N} MM_{k,x}\right)$$

Les composantes $X_{m,y}$ et $X_{m,z}$ sont calculées de façon similaire. Les composantes $X_{m,x}$, $X_{m,y}$ et $X_{m,z}$ sont les valeurs de références calculées lors de l'opération 46 pour les axes de mesures parallèles aux directions, respectivement, X, Y et Z. Ces trois composantes $X_{m,x}$, $X_{m,y}$ et $X_{m,z}$ correspondent aux trois composantes de ce qui est appelé ici un "vecteur de référence".

Ensuite, lors d'une opération 48, pour chaque magnétomètre Mk, une distance dk représentative de l'écart entre les mesures $MM_{k,x}$, $MM_{k,y}$ et $MM_{k,z}$ de ce magnétomètre $M_k$ et les valeurs de référence, respectivement $X_{m,x}$, $X_{m,y}$ et $X_{m,z}$, est calculée. Ici, la distance utilisée est la distance de Mahalanobis.

Pour cela, une matrice centrée $X_c$ de dimension (n, p) est déterminée en modifiant chaque composante de la matrice A à l'aide du champ magnétique moyen $X_m$. Plus précisément, pour construire la première colonne de la matrice $X_c$, la valeur de référence $X_{m,x}$ est soustraite à chacune des composantes $MM_{k,x}$ contenues dans la première colonne de la matrice A. Il est procédé de façon similaire pour construire les deuxième et troisième colonnes de la matrice $X_c$ mais en utilisant, respectivement, les valeurs de référence $X_{m,y}$ et $X_{m,z}$.

Ensuite, une matrice S de covariance est construite à l'aide de la relation suivante : $S = (X_c^T X_c) / (N-1)$. Dans ce texte, l'exposant « $T$ » désigne l'opération matricielle de transposition. La matrice S ainsi obtenue est une matrice de dimension (p, p) qui est inversible. La distance dk de Mahalanobis de chaque magnétomètre Mk est alors calculée, par exemple, à l'aide de la relation suivante : $dk^2 = X_{c,k} S^{-1} X_{c,k}^T$, où $X_{c,k}$ désigne la k-ième ligne de la matrice $X_c$ et l'exposant « $^{-1}$ » indique qu'il s'agit de l'inverse de la matrice S.

On notera que la distance dk ainsi calculée dépend de l'écart entre les normes du premier vecteur de mesure et du vecteur de référence mais aussi de l'écart angulaire entre les directions de ces mêmes vecteurs. La norme d'un vecteur est ici définie comme étant égale à $sqrt(x^2 + y^2 + z_z^2)$, où :

- sqrt(..) est la fonction qui retourne la racine carrée du nombre entre parenthèses, et
- x, y et z sont les composantes du vecteur.

Lors d'une opération 50, il est vérifié si les distances dk calculées satisfont une condition prédéterminée. Si les distances dk calculées satisfont cette condition prédéterminée, alors la présence de mesures aberrantes est détectée et donc la présence d'un perturbateur est détectée. Dans ce cas, la présence d'un perturbateur à proximité du réseau de magnétomètres est signalée. Selon une réalisation particulière, il s'en suit une étape, dans laquelle le ou les capteurs dont les mesures sont perturbées sont identifiés et signalés.

À l'inverse, si les distances dk calculées ne satisfont pas cette condition prédéterminée, alors la présence de mesures aberrantes et donc d'un perturbateur n'est pas détectée. Autrement dit, si les distances dk ne satisfont pas cette condition prédéterminée, l'absence de perturbateur est détectée. Dans ce dernier cas, le signalement de la présence d'un perturbateur est inhibé.

La condition prédéterminée est par exemple enregistrée dans la mémoire 34 lors de la fabrication de l'appareil 16. Cette condition prédéterminée est conçue pour discriminer efficacement une non-uniformité intrinsèque d'une non-uniformité extrinsèque. Par « non-uniformité intrinsèque », on désigne ici une non-uniformité des premières mesures des magnétomètres $M_{ij}$ qui est causée par des éléments intrinsèques à l'appareil 16, c'est-à-dire des éléments qui sont fixés sans aucun degré de liberté au réseau de magnétomètres $M_{ij}$. Par exemple, typiquement, il s'agit de pièces en matériau ferromagnétique comme les pièces ferromagnétiques qui sont situées dans chacun des magnétomètres $M_{ij}$.

Par « non-uniformité extrinsèque », on désigne ici une non-uniformité des premières mesures des magnéto-mètres $M_{ij}$ qui est causée par le perturbateur, c'est-à-dire par un élément extérieur au réseau de magnétomètres $M_{ij}$ et généralement extérieur à l'appareil 16. Le perturbateur est ici généralement un objet magnétique mobile qui peut librement être déplacé par rapport à l'appareil 16. Par exemple, le perturbateur peut être l'aimant 15 du crayon 4 si celui-ci est à proximité du réseau de magnétomètres $M_{ij}$ lors de l'exécution de la phase 40 d'initialisation du réseau de magnétomètres.

Dans ce mode de réalisation, la condition prédéterminée utilisée est la suivante : $S_{d1} \geq \alpha_1 S_{Td1}$, où :

- $S_{d1}$ est la somme des $N_1$ distances dk calculées les plus grandes,

- $S_{Td1}$ est la somme de toutes les distances $d_k$ calculées, et

- $\alpha_1$ est un coefficient prédéterminé supérieur à 0 et inférieur à 1.

Par la suite, cette condition est appelée « condition 1) ».

$N_1$ est un nombre prédéterminé enregistré dans la mémoire 34. Le nombre $N_1$ est supérieur ou égal à un et inférieur à $N_{dmax}$, où $N_{dmax}$ est égal au nombre de distances dk calculées c'est-à-dire ici à N. De préférence, $N_1$ est inférieur ou égal à $N_{dmax}/2$ ou $N_{dmax}/3$. De préférence, Ni est également supérieur ou égal à deux ou trois. Ici, $N_1$ est choisi égal à dix ou onze.

Le coefficient $\alpha_1$ permet de régler la sensibilité de la détection de la présence d'un perturbateur. En pratique, lorsque $N_1$ est choisi inférieur ou égal à $N_{dmax}/2$ ou $N_{dmax}/3$, $\alpha_1$ est choisi supérieur ou égal à 0,5 ou à 0,7. Ici, $\alpha_1$ est égal à 0,7.

Il a été découvert que la condition 1) est, parmi l'ensemble des conditions possibles présentées à la fin de cette description, celle qui permet de détecter, de la façon la plus fiable, la présence ou l'absence d'un perturbateur.

À ce sujet, les essais suivants ont été réalisés en utilisant le crayon 4 en tant que perturbateur :

- Essai 1) : le crayon 4 est posé horizontalement à un endroit quelconque sur la face du réseau de magnétomètres puis l'étape 42 de détection de la présence d'un perturbateur est exécutée.

- Essai 2) : le crayon 4 est disposé le long d'un bord du réseau de magnétomètres parallèle à la direction X ou Y puis l'étape 42 de détection de la présence d'un perturbateur est exécutée.

- Essai 3) : le crayon 4 est maintenu vertical, la pointe 8 en appui à un endroit quelconque sur le support 6, puis l'étape 42 de détection de la présence d'un perturbateur est exécutée.

Chacun des essais 1) à 3) a été réitéré plusieurs fois en modifiant à chaque fois la position du crayon 4 tout en respectant les conditions de l'essai. Dans le cas de l'essai 1, le taux de détection correcte, également connu sous l'acronyme TPR (« True Positive Rate »), et le taux de fausse détection, connu sous l'acronyme FPR (« False Positive Rate ») sont tous les deux égaux à 100 % . Dans le cas de l'essai 2, le taux TPR est supérieur à 99,6 % et le taux FPR est inférieur à 0,3 %. Dans le cas de l'essai 3, le taux TPR est supérieur à 50 % ou 70 % selon l'appareil 16 utilisé et le taux FPR est inférieur à 0,2 %.

Si la condition 1) est satisfaite, les magnétomètres Mk identifiés comme étant perturbés par la présence du perturbateur sont, par exemple, les $N_1$ magnétomètres dont les distances $d_k$ sont les plus grandes.

Si à l'issue de l'étape 42 de détection de la présence d'un perturbateur, la présence d'aucun perturbateur n'a été signalée, le réglage des coefficients de correction à partir des premières mesures acquises lors de l'opération 44 de mesure est autorisé. Ainsi, le procédé se poursuit par une étape 52 de réglage automatique des coefficients de correction des magnétomètres $M_{ij}$.

Par exemple, lors de l'étape 52, pour chaque magnétomètre $M_k$, les nouvelles valeurs des trois coefficients de correction associés respectivement aux directions X, Y et Z sont corrigés en y retranchant les mesures, respectivement, $MM_{k,x}$, $MM_{k,y}$ et $MM_{k,z}$. Ainsi, par la suite, chaque nouvelle mesure corrigée est obtenue en utilisant ces nouvelles valeurs des coefficients de correction. Ces nouvelles mesures sont appelées par la suite « deuxièmes mesures ». Cela a pour conséquence de compenser non seulement les erreurs de mesure mais aussi le champ magnétique terrestre mesuré lors de l'opération 44 de mesure. Ainsi, après l'étape 52 de réglage des coefficients de correction, en absence de perturbateur, les deuxièmes mesures corrigées des magnétomètres $M_{ij}$ sont toutes nulles à une marge de tolérance prédéterminée près.

À l'issue de l'étape 52 de réglage des coefficients de correction, la phase 40 d'initialisation est achevée et le procédé se poursuit par une phase 58 d'utilisation de deuxièmes mesures, ici, pour relever la trace de la pointe 8 du crayon 4.

Si à l'issue de l'étape 42 de détection de la présence d'un perturbateur, la présence d'un perturbateur a été signalée, en réponse à ce signalement, le réglage des coefficients de correction à partir des premières mesures acquises lors de l'opération 44 de mesure est interdit. Pour cela, l'exécution de l'étape 52 de réglage des coefficients de correction est inhibée. Par exemple, dans un premier mode de réalisation, l'utilisation du réseau de magnétomètres est bloquée et l'exécution de la phase 58 d'utilisation des deuxièmes mesures est interdite. Dans un deuxième mode de réalisation, en réponse au signalement de la présence d'un perturbateur :

- le procédé retourne à l'étape 42 de détection de la présence d'un perturbateur, ou

- le procédé se poursuit par la phase 58 d'utilisation des deuxièmes mesures mais en utilisant les coefficients de correction réglés lors d'une précédente exécution de l'étape 52 de réglage des coefficients de correction ou en utilisant les valeurs par défaut de ces coefficients de correction.

La phase 58 d'utilisation des deuxièmes mesures est par exemple réalisée comme décrit dans la demande WO2013144338. Par conséquent, cette phase 58 n'est pas décrite ici plus en détail et le lecteur est renvoyé au texte de cette demande pour plus d'informations. Lors de cette phase 58, des deuxièmes mesures des magnétomètres $M_{ij}$ sont acquises à intervalle régulier par l'unité 30 puis corrigées à l'aide des coefficients de correction. Ensuite, seules les deuxièmes mesures ainsi corrigées sont utilisées pour déterminer la position et l'orientation de l'aimant 15 et donc la position de la pointe 8.

La figure 5 représente un autre procédé de relevé de la trace du crayon 4 susceptible d'être implémenté dans l'appareil 16 à la place du procédé de la figure 4. Le procédé de la figure 5 est identique au procédé de la figure 4 sauf que la phase 40 d'initialisation est remplacée par une phase 60. La phase 60 est identique à la phase 40 d'initialisation du réseau de magnétomètres sauf que l'étape 42 de détection de la présence d'un perturbateur est remplacée par une étape 62 de détection d'un perturbateur. L'étape 62 est identique à l'étape 42 de détection de la présence d'un perturbateur sauf que :

- les opérations 46 de calcul d'une valeur de référence et 48 de calcul de la distance dk sont remplacées par une opération 66, et

- l'opération 50 de vérification de la condition prédéterminée est remplacée par une opération 70.

Lors de l'opération 66, pour chaque magnétomètre Mk, l'unité 30 calcule l'intensité $B_k$ du champ magnétique mesuré par ce magnétomètre à partir des mesures $MM_{k,x}$, $MM_{k,y}$, $MM_{k,z}$ acquises lors de l'opération 44 de mesure. Classiquement, l'intensité $B_k$ est calculée à l'aide de la relation suivante : $B_k = \text{sqrt}(MM_{k,x}^2 + MM_{k,y}^2 + MM_{k,z}^2)$, où sqrt(..) est la fonction qui retourne la racine carrée du nombre entre parenthèses.

L'opération 70 est identique à l'opération 50 de vérification de la condition prédéterminée sauf que la condition 1) s'exprime alors, par exemple, sous la forme suivante : $S_{B1} \geq \alpha_1 S_{TB1}$, où :

- $S_{B1}$ est la somme des $N_1$ intensités $B_k$ les plus grandes parmi l'ensemble des intensités $B_k$ calculées,

- $S_{TB1}$ est la somme de toutes les intensités $B_k$ calculées.

Chapitre II : Variantes :

Chapitre II.1. Variantes de la distance $d_k$ :

D'autres méthodes sont possibles pour calculer une distance représentative de l'écart entre les mesures d'un capteur et les mesures des autres capteurs. Par exemple, lors de l'opération 48 de calcul de la distance dk, le champ magnétique moyen $X_m$ peut être remplacé par un champ magnétique médian. Dans ce cas, les valeurs de référence $X_{m,x}$, $X_{m,y}$ et $X_{m,z}$ sont égales à la valeur médiane, au lieu de la valeur moyenne, des mesures réalisées selon les axes de mesure X, Y et Z.

La distance peut également être calculée en utilisant d'autres valeurs de référence qu'une valeur moyenne ou médiane. Par exemple, une valeur de référence peut être prise égale au maximum ou au minimum des mesures des N capteurs selon un axe de mesure.

Il existe aussi d'autres méthodes de calcul de la distance dk de Mahalanobis. Par exemple, l'unité 30 réalise une analyse en composantes principales connue sous l'acronyme PCA (« Principal Component Analysis ») pour déterminer les trois directions u, v et w de variance maximale qui forme une base orthonormée. Ensuite, la distance dk est calculée à l'aide de la relation suivante $d_k^2 = y_k^2 L^{-1}$, où :

- yk est la k-ième ligne d'une matrice Y de dimension (n, p) qui contient chacune des projections orthogonales du vecteur $X_{c,k}$ sur, respectivement, les axes u, v et w, et
- L est le vecteur dont les composantes sont formées par les valeurs propres de la matrice S de covariance.

La distance de Mahalanobis peut être remplacée par une autre distance comme, par exemple, une distance Euclidienne.

En variante, les premières mesures utilisées sont directement les mesures brutes des magnétomètres sans leur appliquer une quelconque correction.

Chapitre II.2. Variantes de la condition prédéterminée :

D'autres conditions prédéterminées que la condition 1) précédemment décrite peuvent être utilisées. Par exemple, la condition 1) peut être remplacée par l'une des conditions suivantes :

- Condition 2) : si $N_2$ distances $d_k$ sont supérieures à un seuil $S_2$ prédéterminé, alors la présence d'un perturbateur est détectée, où N2 est supérieur ou égal à un et inférieur ou égal à $N_{dmax}$. De préférence, le seuil S2 est calculé en fonction de $\mu_d$ et $\varepsilon_d$, où :

    - $\mu_d$ est la valeur moyenne des distances dk calculées, et

    - $\varepsilon_d$ est l'écart-type de la distribution des distances dk calculées autour de la valeur $\mu_d$.

Par exemple, le seuil S2 est calculé à l'aide de la relation suivante : $S_2 = \mu_d + \beta_d \varepsilon_d$, où $\beta_d$ est une constante prédéterminée.

- Condition 3) : si N3 distances dk sont supérieures à un seuil S3 prédéterminé, alors la présence d'un perturbateur est détectée, où N3 est supérieur ou égal à un et inférieur ou égal à $N_{dmax}$. De préférence, le seuil S3 est calculé en fonction de $\mu_m$ et $\varepsilon_m$, où :

    - $\mu_m$ est la valeur médiane des distances $d_k$ calculées, et

    - $\varepsilon_m$ est la déviation maximale en valeur absolue également connus sous l'acronyme MAD (Maximum Absolute Déviation).

Par exemple, le seuil S3 est calculé à l'aide de la relation suivante : $S_3 = \mu_m + \beta_m \varepsilon_m$, où $\beta_m$ est une constante prédéterminée.

Les différentes conditions décrites ici peuvent être utilisées quel que soit le mode de calcul de la distance. Elles peuvent aussi facilement être adaptées au cas où la distance $d_k$ est remplacée par une autre grandeur comme l'intensité $B_k$.

D'autres conditions prédéterminées peuvent être générées par exemple en combinant à l'aide d'opérateurs logiques plusieurs des conditions 1) à 3) précédemment décrites. Par exemple, en variante, la condition prédéterminée est : « condition 1) » OU « condition 2) » où « condition 1) » et « condition 2) » sont, respectivement, les conditions 1) et 2)-précédemment décrites.

Chapitre II.3. Autres variantes :

Dans une version simplifiée, lors de l'opération 44, les premières mesures ne subissent pas une première correction en utilisant les précédentes valeurs des coefficients de correction ou les valeurs par défaut de ces coefficients de correction.

Dans un autre mode de réalisation, lorsqu'un perturbateur est détecté à l'issue de l'étape 42 de détection de la présence d'un perturbateur, le procédé se poursuit par une étape automatique de signalement de la présence de ce perturbateur. Par exemple, lors de cette étape de signalement, l'unité 30 commande une interface homme-machine pour signaler à un utilisateur de l'appareil 16 la présence d'un perturbateur à proximité du réseau de capteurs. Par exemple, l'unité 30 commande l'affichage d'un message écrit ou le jeu d'un message sonore pour signaler la présence d'un perturbateur. Ce message peut également demander à l'utilisateur d'éloigner le perturbateur de l'appareil 16 pendant la phase d'initialisation.

Pour la mise en œuvre de la phase d'initialisation, il n'est pas nécessaire que les distances entre les magnétomètres soient connues. Il n'est pas non plus nécessaire que les magnétomètres soient fixés les uns aux autres sans aucun degré de liberté. Par exemple, en variante, les liaisons mécaniques entre les magnétomètres autorisent un déplacement en translation des magnétomètres les uns par rapport aux autres tout en interdisant tout déplacement en rotation des magnétomètres les uns par rapport aux autres.

En variante, si les orientations les unes par rapport aux autres des axes de mesure des magnétomètres $M_{ij}$ sont connues, alors il n'est pas nécessaire que les axes de mesure de ces différents magnétomètres $M_{ij}$ soient parallèles

entre eux. En effet, par un simple changement de repère, l'unité 30 est capable de convertir les mesures le long des axes de mesure d'un magnétomètre donné en mesures réalisées, par exemple, le long des directions X, Y et Z du repère XYZ.

Les différentes variantes de la structure du système décrites dans le document WO2013144338 sont applicables à la structure du système 2 décrit ici. De même les différentes variantes du procédé de relevé de la trace d'un crayon décrites le document WO2013144338 sont applicables ici.

Le réseau de magnétomètres $M_{ij}$, et donc la phase 40 ou 60 d'initialisation, peut être utilisé dans d'autres appareils qu'un appareil de relevé de la trace d'un crayon. Par exemple, le procédé d'initialisation décrit ici peut aussi être implémenté dans les appareils décrits dans les documents suivants : WO2014135421, WO2014079740 et WO2014180796.

De nombreux autres modes de réalisation de l'étape 52 de réglage automatique des coefficients de correction sont possibles. Par exemple, dans un autre mode de réalisation, les coefficients de correction des magnétomètres $M_{ij}$ sont réglés de manière à compenser seulement les erreurs de mesure sans compenser le champ magnétique terrestre. Pour cela, à titre d'illustration, pour chaque magnétomètre $M_{ij}$, les trois coefficients de correction associés, respectivement aux directions X, Y et Z, sont pris égaux à, respectivement, $MM_{k,x} - X_{m,x}$, $MM_{k,y} - X_{m,y}$ et $MM_{k,z} - X_{m,z}$.

Ce qui a été décrit ici dans le cas particulier où les capteurs sont des magnétomètres s'applique à tout réseau de capteurs à au moins deux axes de mesure. En particulier, cela s'applique à des réseaux de capteurs mesurant une autre grandeur physique que le champ magnétique. Par exemple, la grandeur physique mesurée par les capteurs de cet autre réseau peut être une force, une pression, une vitesse ou une accélération. Ainsi, ce qui a été décrit s'applique à des réseaux de capteurs de force ou de pression, à des réseaux d'accéléromètres ou à des réseaux de gyromètres ou tout autre réseau de capteurs.

Ce qui a été décrit ici s'applique aussi à tout réseau de capteurs dans lequel chaque capteur comporte plus de trois axes de mesure non colinéaires ou, au contraire, seulement deux axes de mesure non colinéaires. En particulier, ce qui a été décrit ici s'applique à des réseaux de capteurs de pression dans lequel chaque capteur est apte à mesurer la pression selon une direction normale et une force de cisaillement selon une direction orthogonale à cette direction normale. Par exemple, un tel capteur est décrit dans le document US20100162832A1.

La condition 1) peut être mise en œuvre même si la distance calculée n'est pas à la fois fonction de l'écart entre les normes des vecteurs de mesure et de référence et de l'écart angulaire entre ces mêmes vecteurs. Par exemple, la condition 1) peut être mise en œuvre dans le cas où la distance calculée dépend seulement de l'écart entre les normes des vecteurs de mesure et de référence ou seulement de l'écart angulaire entre le vecteur de mesure et le vecteur de référence.

Chapitre III : Avantages des modes de réalisation décrits:

Le fait de détecter des mesures aberrantes dans les premières mesures permet de signaler la présence d'un perturbateur. Ainsi, l'absence de fiabilité des premières mesures est signalée de sorte que des mesures correctives ou préventives peuvent être ensuite mises en œuvre pour ne pas exploiter des premières mesures non-fiables. Par exemple, comme décrit ci-dessus, lorsque la présence d'un perturbateur est signalée, le réglage des coefficients de corrections à partir des premières mesures est inhibé. Le fonctionnement du réseau de capteur peut aussi être interdit. De plus, la distance dk calculée est à la fois fonction :

- de l'écart entre les normes du premier vecteur de mesure et du vecteur de référence, et
- de l'écart angulaire entre le premier vecteur de mesure et le vecteur de référence,

Ainsi, si un perturbateur modifie uniquement la direction du premier vecteur de mesure sans en modifier la norme, cela pourra être détecté. Ceci est avantageux par rapport aux procédés qui se contentent de comparer la norme du premier vecteur de mesure à la norme du vecteur de référence pour détecter la présence d'une mesure aberrante. Ainsi, le procédé d'initialisation décrit ici est plus sensible et donc plus fiable.

Le fait d'utiliser une distance entre ce que mesure un capteur et une valeur de référence pour cette mesure permet de limiter le taux de fausse détection et le taux de fausse absence de détection par rapport à un procédé identique mais utilisant directement l'amplitude ou la norme de la grandeur physique mesurée et non pas une distance par rapport à une valeur de référence.

Le fait d'utiliser la condition 1) permet de limiter le taux de fausse détection et le taux de fausse absence de détection par rapport à d'autres conditions possibles, comme par exemple les conditions 2) et 3) précédemment décrites.

Le fait d'utiliser la distance de Mahalanobis permet aussi d'augmenter la fiabilité de la détection de la présence d'un perturbateur par rapport à d'autres procédés identiques mais dans lesquels une autre distance, comme par exemple la distance euclidienne, est utilisée.

Le fait d'utiliser des valeurs préenregistrées pour régler les coefficients de correction lorsqu'un perturbateur est détecté permet d'obtenir un réglage des capteurs qui est meilleur que celui qui serait obtenu si l'étape de réglage était exécutée en présence de ce perturbateur avec des coefficients de correction qui seraient calculés en présence de perturbateur. Cela limite donc les dégradations du fonctionnement du réseau de capteurs.

**Revendications**

1. Procédé d'initialisation d'un réseau de capteurs comportant au moins quatre capteurs, les capteurs étant reliés mécaniquement ensemble et étant configurés pour mesurer une même grandeur physique selon au moins deux axes non-colinéaires de mesure, ce procédé comportant :

   - l'acquisition (44) de premières mesures de la grandeur physique réalisées par les capteurs, ces premières mesures précédant des deuxièmes mesures, les premières mesures d'un capteur selon chacun de ses axes de mesure formant un premier vecteur de mesure,
   - une exécution (46, 48, 50) d'un test statistique sur un ensemble constitué par les premières mesures réalisées par les capteurs, ce test statistique étant apte à détecter au moins une mesure aberrante dans les premières mesures causées par une présence d'un objet, appelé perturbateur, ce perturbateur modifiant de façon non-uniforme la grandeur physique mesurée,
   - si l'exécution du test statistique détecte au moins une mesure aberrante, alors le procédé comprend le signalement (50) de la présence du perturbateur, et
   - si l'exécution du test statistique ne détecte pas au moins une mesure aberrante, alors le procédé comprend l'acquisition (58) des deuxièmes mesures de la grandeur physique réalisées par les capteurs,

   **caractérisé en ce que** l'exécution du test statistique comporte :

   - pour chaque axe de mesure, un calcul (46) d'une valeur de référence pour les premières mesures des capteurs, les valeurs de référence calculées pour chaque axe de mesure formant un vecteur de référence,
   - pour chaque capteur, le calcul (48) d'une distance représentative de l'écart entre le premier vecteur de mesure de ce capteur et le vecteur de référence calculée, cette distance étant fonction :

      • de l'écart entre les normes du premier vecteur de mesure et du vecteur de référence, et
      • de l'écart angulaire entre le premier vecteur de mesure et le vecteur de référence,

   - la vérification (50) que les distances calculées satisfont une condition prédéterminée et la détection de la présence d'au moins une mesure aberrante si les distances calculées satisfont cette condition prédéterminée et, en alternance, lorsque les distances calculées ne satisfont pas cette condition prédéterminée, l'absence de détection d'au moins une mesure aberrante.

2. Procédé selon la revendication 1, dans lequel le procédé comprend l'identification et le signalement (50) d'au moins un capteur ayant réalisé une mesure aberrante.

3. Procédé selon l'une quelconque des revendications précédentes, dans lequel la condition prédéterminée est la condition suivante : $S_{d1} \geq \alpha_1 S_{Td1}$, où :

   - $S_{d1}$ est la somme des $N_1$ distances calculées les plus grandes, où $N_1$ est un nombre supérieur ou égal à un et inférieur ou égal à $N_{dmax}/2$ ou $N_{dmax}/3$, où $N_{dmax}$ est égal au nombre de distances calculées,
   - $S_{Td1}$ est la somme de toutes les distances calculées, et
   - $\alpha_1$ est un coefficient prédéterminé supérieur à zéro et inférieur à un.

4. Procédé selon l'une quelconque des revendications précédentes, dans lequel la distance calculée est la distance de Mahalanobis.

5. Procédé selon l'une quelconque des revendications précédentes, dans lequel le calcul de la valeur de référence comporte le calcul d'une valeur moyenne ou médiane des premières mesures.

6. Procédé selon l'une quelconque des revendications précédentes, dans lequel :

   - si l'exécution du test statistique ne détecte pas au moins une mesure aberrante, le procédé comporte le réglage (52) de coefficients de correction en fonction des premières mesures pour compenser des erreurs de mesures des capteurs, chaque capteur étant associé à au moins un de ces coefficients de correction, puis

- la correction (58) des deuxièmes mesures à l'aide de ces coefficients de corrections réglés, puis
- l'utilisation (58) des deuxièmes mesures corrigées lors de toutes étapes ultérieures exploitant ces deuxièmes mesures.

**7.** Support (34) d'enregistrement d'informations, lisible par un microprocesseur (32), **caractérisé en ce qu'**il comporte des instructions pour l'exécution d'un procédé conforme à l'une quelconque des revendications précédentes, lorsque ces instructions sont exécutées par l'unité (30) de traitement selon la revendication 8.

**8.** Unité (30) de traitement de données comprenant un processeur configuré pour la mise en œuvre d'un procédé d'initialisation conforme à l'une quelconque des revendications 1 à 6, cette unité de traitement étant configurée pour :

- acquérir des premières mesures de la grandeur physique réalisées par les capteurs, ces premières mesures précédant des deuxièmes mesures, les premières mesures d'un capteur selon chacun de ses axes de mesure formant un premier vecteur de mesure,
- exécuter un test statistique sur un ensemble constitué par les premières mesures réalisées par les capteurs, ce test statistique étant apte à détecter au moins une mesure aberrante dans les premières mesures causées par une présence d'un objet, appelé perturbateur, ce perturbateur modifiant de façon non-uniforme la grandeur physique mesurée,
- si l'exécution du test statistique détecte au moins une mesure aberrante, alors signaler la présence du perturbateur, et
- si l'exécution du test statistique ne détecte pas au moins une mesure aberrante, alors acquérir les deuxièmes mesures de la grandeur physique réalisées par les capteurs

**caractérisée en ce que** l'unité de traitement est également configurée pour, lors de l'exécution du test statistique, réaliser les opérations suivantes :

- pour chaque axe de mesure, calculer une valeur de référence pour les premières mesures des capteurs, les valeurs de référence calculées pour chaque axe de mesure formant un vecteur de référence,
- pour chaque capteur, calculer une distance représentative de l'écart entre le premier vecteur de mesure de ce capteur et le vecteur de référence calculée, cette distance étant fonction :

  • de l'écart entre les normes du premier vecteur de mesure et du vecteur de référence, et
  • de l'écart angulaire entre le premier vecteur de mesure et le vecteur de référence,

- vérifier que les distances calculées satisfont une condition prédéterminée et détecter la présence d'au moins une mesure aberrante si les distances calculées satisfont cette condition prédéterminée et, en alternance, lorsque les distances calculées ne satisfont pas cette condition prédéterminée, établir l'absence d'au moins une mesure aberrante.

**9.** Système comportant :

- un réseau de capteurs comportant au moins quatre capteurs, les capteurs étant reliés mécaniquement ensemble et étant configurés pour mesurer une même grandeur physique selon au moins deux axes non-colinéaires de mesure, et
- une unité (30) de traitement,

**caractérisé en ce que** l'unité (30) de traitement est conforme à la revendication 8.

**10.** Système selon la revendication 9, dans lequel chaque capteur est choisi dans le groupe constitué d'un magnétomètre, d'un capteur de pression, d'un capteur de force, d'un accéléromètre et d'un gyromètre.

**11.** Système selon la revendication 9, dans lequel chaque capteur comporte au moins un premier et un second axes de mesure, les premiers axes de mesure étant parallèles entre eux et les seconds axes de mesure étant parallèles entre eux.

**12.** Système selon la revendication 9, dans lequel chaque capteur est un magnétomètre tri-axe ou un capteur de pression biaxes.

**13.** Système selon la revendication 12, dans lequel :

- le système comporte au moins un aimant permanent (15) apte à être fixé sans aucun degré de liberté sur un crayon,
- chaque capteur du réseau de capteurs est apte à mesurer l'amplitude du champ magnétique le long d'au moins trois axes non-colinéaires de mesure,
- l'unité (30) de traitement est apte à relever la trace du crayon dessinée sur une surface d'écriture, l'unité (30) de traitement étant configurée à cet effet pour localiser l'aimant permanent fixé sur le crayon et pour déduire de la localisation de l'aimant permanent la position de la pointe (8) du crayon.

**Patentansprüche**

**1.** Verfahren zum Initialisieren eines Sensornetzes, das wenigstens vier Sensoren enthält, wobei die Sensoren mechanisch miteinander verbunden sind und konfiguriert sind, dieselbe physikalische Größe längs wenigstens zweier nicht kolinearer Messachsen zu messen, wobei dieses Verfahren Folgendes umfasst:

- Erfassen (44) erster Messungen der ersten physikalischen Größe, die durch die Sensoren ausgeführt werden, wobei diese ersten Messungen zweiten Messungen vorhergehen, wobei die ersten Messungen eines Sensors längs jeder seiner Messachsen einen ersten Messvektor bilden,
- Ausführen (46, 48, 50) einer statistischen Prüfung an einer Gesamtheit, die aus den ersten Messungen, die von den Sensoren ausgeführt werden, gebildet wird, wobei diese statistische Prüfung wenigstens eine abweichende Messung in den ersten Messungen, die durch ein Vorhandensein eines Objekts, das Störer genannt wird, verursacht wird, detektieren kann, wobei dieser Störer die gemessene physikalische Größe ungleichmäßig modifiziert,
- wobei das Verfahren dann, wenn die Ausführung der statistischen Prüfung wenigstens eine abweichende Messung detektiert, das Melden (50) des Vorhandenseins des Störers umfasst und
- wobei das Verfahren dann, wenn die Ausführung der statistischen Prüfung keine abweichende Messung detektiert, das Erfassen (58) zweiter Messungen der physikalischen Größe, die durch die Sensoren ausgeführt werden, umfasst,

**dadurch gekennzeichnet, dass** die Ausführung der statistischen Prüfung Folgendes umfasst:

- für jede Messachse Berechnen (56) eines Referenzwertes für die ersten Messungen der Sensoren, wobei die für jede Messachse berechneten Referenzwerte einen Referenzvektor bilden,
- für jeden Sensor Berechnen (48) einer Distanz, die den Abstand zwischen dem ersten Messvektor dieses Sensors und dem berechneten Referenzvektor darstellt, wobei diese Distanz abhängt von:

  • der Differenz zwischen den Beträgen des ersten Messvektors und des Referenzvektors und
  • der Winkeldifferenz zwischen dem ersten Messvektor und dem Referenzvektor, und

- Verifizieren (50), dass die berechneten Distanzen eine vorgegebene Bedingung erfüllen und Detektieren des Vorhandenseins wenigstens einer abweichenden Messung dann, wenn die berechneten Distanzen diese vorgegebene Bedingung erfüllen, und alternativ dann, wenn die berechneten Distanzen diese vorgegebene Bedingung nicht erfüllen, Ausbleiben des Detektierens wenigstens einer abweichenden Messung.

**2.** Verfahren nach Anspruch 1, wobei das Verfahren das Identifizieren und das Melden (50) wenigstens eines Sensors, der eine abweichende Messung ausgeführt hat, umfasst.

**3.** Verfahren nach einem der vorhergehenden Ansprüche, wobei die vorgegebene Bedingung die folgende Bedingung ist: $S_{d1} \geq \alpha_1 S_{Td1}$, wobei:

- $S_{d1}$ die Summe aus $N_1$ größten berechneten Distanzen ist, wobei $N_1$ eine Zahl größer oder gleich eins und kleiner oder gleich $N_{dmax}/2$ oder $N_{dmax}/3$ ist, wobei $N_{dmax}$ gleich der Anzahl berechneter Distanzen ist,
- $S_{Td1}$ die Summe aller berechneter Distanzen ist und
- $\alpha_1$ ein vorgegebener Koeffizient größer als null und kleiner als eins ist.

**4.** Verfahren nach einem der vorhergehenden Ansprüche, wobei die berechnete Distanz die Mahalanobis-Distanz ist.

**5.** Verfahren nach einem der vorhergehenden Ansprüche, wobei das Berechnen des Referenzwertes das Berechnen eines Mittel- oder Medianwertes der ersten Messungen umfasst.

**6.** Verfahren nach einem der vorhergehenden Ansprüche, wobei:

- das Verfahren dann, wenn die Ausführung der statistischen Prüfung keine abweichende Messung detektiert, das Regulieren (52) von Korrekturkoeffizienten als Funktion der ersten Messungen, um Messfehler der Sensoren zu kompensieren, wobei jedem Sensor wenigstens einer dieser Korrekturkoeffizienten zugeordnet wird, dann
- das Korrigieren (58) zweiter Messungen mit Hilfe dieser regulierten Korrekturkoeffizienten und dann
- das Verwenden (58) der korrigierten zweiten Messungen in allen späteren Schritten, die diese zweiten Messungen verwenden, umfasst.

**7.** Datenaufzeichnungsträger (34), der durch einen Mikroprozessor (32) gelesen werden kann, **dadurch gekennzeichnet, dass** er Anweisungen für die Ausführung eines Verfahrens nach einem der vorhergehenden Ansprüche, wenn diese Anweisungen von der Verarbeitungseinheit (30) nach Anspruch 8 ausgeführt werden, enthält.

**8.** Datenverarbeitungseinheit (30), die einen Prozessor enthält, der für die Ausführung eines Initialisierungsverfahrens nach einem der Ansprüche 1 bis 6 konfiguriert ist, wobei diese Verarbeitungseinheit konfiguriert ist zum:

- Erfassen erster Messungen der physikalischen Größe, die von den Sensoren ausgeführt werden, wobei diese ersten Messungen zweiten Messungen vorhergehen, wobei die ersten Messungen eines Sensors längs jeder seiner Messachsen einen ersten Messvektor bilden,
- Ausführen einer statistischen Prüfung an einer Gesamtheit, die aus den von den Sensoren ausgeführten ersten Messungen gebildet wird, wobei diese statistische Prüfung wenigstens eine abweichende Messung unter den ersten Messungen, die durch das Vorhandensein eines Objekts, das Störer genannt wird, verursacht wird, detektieren kann, wobei dieser Störer die gemessene physikalische Größe ungleichmäßig modifiziert,
- falls die Ausführung der statistischen Prüfung wenigstens eine abweichende Messung detektiert, Melden des Vorhandenseins des Störers und
- falls die Ausführung der statistischen Prüfung keine abweichende Messung detektiert, Erfassen der zweiten Messungen der physikalischen Größe, die von den Sensoren ausgeführt werden,

**dadurch gekennzeichnet, dass** die Verarbeitungseinheit außerdem bei der Ausführung der statistischen Prüfung konfiguriert ist, die folgenden Operationen auszuführen:

- für jede Messachse Berechnen eines Referenzwertes für die ersten Messungen der Sensoren, wobei die für jede Messachse berechneten Referenzwerte einen Referenzvektor bilden,
- für jeden Sensor Berechnen einer Distanz, die den Abstand zwischen dem ersten Messvektor dieses Sensors und dem berechneten Referenzvektor darstellt, wobei diese Distanz abhängt von:

• der Differenz zwischen den Beträgen des ersten Messvektors und des Referenzvektors und
• der Winkeldifferenz zwischen dem ersten Messvektor und dem Referenzvektor,

- Verifizieren, dass die berechneten Distanzen eine vorgegebene Bedingung erfüllen und Detektieren des Vorhandenseins wenigstens einer abweichenden Messung, falls die berechneten Distanzen diese vorgegebene Bedingung erfüllen, und alternativ dann, wenn die berechneten Distanzen diese vorgegebenen Bedingungen nicht erfüllen, Angeben des Ausbleibens wenigstens einer abweichenden Messung.

**9.** System, das Folgendes umfasst:

- ein Sensornetz, das wenigstens vier Sensoren umfasst, wobei die Sensoren mechanisch miteinander verbunden sind und konfiguriert sind, dieselbe physikalische Größe längs zweier nicht kolinearer Messachsen zu messen und
- eine Verarbeitungseinheit (30),

**dadurch gekennzeichnet, dass** die Verarbeitungseinheit (30) wie in Anspruch 8 definiert beschaffen ist.

**10.** System nach Anspruch 9, wobei jeder Sensor aus einer Gruppe gewählt ist, die aus einem Magnetometer, einem Drucksensor, einem Kraftsensor, einem Beschleunigungsmesser und einem Gyrometer gebildet ist.

**11.** System nach Anspruch 9, wobei jeder Sensor wenigstens eine erste und eine zweite Messachse aufweist, wobei die ersten Messachsen zueinander parallel sind und die zweiten Messachsen zueinander parallel sind.

**12.** System nach Anspruch 9, wobei jeder Sensor ein dreiachsiges Magnetometer oder ein zweiachsiger Drucksensor ist.

**13.** System nach Anspruch 12, wobei:

- das System wenigstens einen Permanentmagneten (15) aufweist, der ohne jeglichen Freiheitsgrad an einem Stift befestigt sein kann,
- jeder Sensor des Sensornetzes die Amplitude des Magnetfeldes längs wenigstens dreier nicht kolinearer Messachsen messen kann,
- die Verarbeitungseinheit (30) die Bahn des Stifts, die auf eine Schreiboberfläche gezeichnet wird, erfassen kann, wobei die Verarbeitungseinheit (30) hierzu konfiguriert ist, den an dem Stift befestigten Permanentmagneten zu lokalisieren und aus der Lokalisierung des Permanentmagneten die Position der Spitze (8) des Stifts abzuleiten.

**Claims**

**1.** Method for initializing a sensor array comprising at least four sensors, the sensors being mechanically joined together and being configured to measure the same physical quantity along at least two non-collinear measurement axes, this method comprising:

- acquiring (44) first measurements of the physical quantity, these first measurements being measured by the sensors and preceding second measurements, the first measurements of a sensor along each of its measurement axes forming a first measurement vector,
- executing (46, 48, 50) a statistical test on a set consisting of the first measurements measured by the sensors, this statistical test being able to detect at least one aberrant measurement in the first measurements caused by a presence of an object, called a disruptor, this disruptor modifying the measured physical quantity nonuniformly,
- if the execution of the statistical test detects at least one aberrant measurement, then the method comprises signaling (50) the presence of the disruptor, and
- if the execution of the statistical test does not detect at least one aberrant measurement, then the method comprises acquiring (58) second measurements of the physical quantity, these second measurements being measured by the sensors,

**characterized in that** the execution of the statistical test comprises:

- for each measurement axis, computing (46) a reference value for the first measurements of the sensors, the reference values computed for each measurement axis forming a reference vector,
- for each sensor, computing (48) a distance representative of the discrepancy between the first measurement vector of this sensor and the computed reference vector, this distance depending on:

  • the discrepancy between the norms of the first measurement vector and of the reference vector, and
  • the angular discrepancy between the first measurement vector and the reference vector,

- verifying (50) that the computed distances meet a preset condition and detecting the presence of at least one aberrant measurement if the computed distances meet this preset condition and, conversely, when the computed distances do not meet this preset condition, not detecting at least one aberrant measurement.

**2.** Method according to Claim 1, wherein the method comprises identifying and signaling (50) at least one sensor having measured an aberrant measurement.

**3.** Method according to either one of the preceding claims, wherein the preset condition is the following condition: $S_{d1} \geq \alpha_1 S_{Td1}$, where:

- $S_{d1}$ is the sum of the $N_1$ largest computed distances, where $N_1$ is a number higher than or equal to one and lower than or equal to $N_{dmax}/2$ or $N_{dmax}/3$, where $N_{dmax}$ is equal to the number of computed distances,
    - $S_{Td1}$ is the sum of all the computed distances, and
    - $\alpha_1$ is a preset coefficient higher than zero and lower than one.

4. Method according to any one of the preceding claims, wherein the computed distance is the Mahalanobis distance.

5. Method according to any one of the preceding claims, wherein the computation of the reference value comprises computing a mean or median value of the first measurements.

6. Method according to any one of the preceding claims, wherein:

    - if the execution of the statistical test does not detect at least one aberrant measurement, the method comprises adjusting (52) correction coefficients depending on the first measurements in order to compensate for sensor measurement errors, each sensor being associated with at least one of these correction coefficients, then
    - correcting (58) the second measurements using these adjusted correction coefficients, then
    - using (58) the corrected second measurements in any subsequent steps exploiting these second measurements.

7. Data storage medium (34) that is readable by a microprocessor (32), **characterized in that** the medium comprises instructions for the execution of a method according to any one of the preceding claims, when these instructions are executed by the processing unit (30) according to Claim 8.

8. Data processing unit (30) comprising a processor configured to implement an initializing method according to any one of Claims 1 to 6, this processing unit being configured to:

    - acquire first measurements of the physical quantity, these first measurements being measured by the sensors and preceding second measurements, the first measurements of a sensor along each of its measurement axes forming a first measurement vector,
    - execute a statistical test on a set consisting of the first measurements measured by the sensors, this statistical test being able to detect at least one aberrant measurement in the first measurements caused by a presence of an object, called a disruptor, this disruptor modifying the measured physical quantity nonuniformly,
    - if the execution of the statistical test detects at least one aberrant measurement, then signal the presence of the disruptor, and
    - if the execution of the statistical test does not detect at least one aberrant measurement, then acquire second measurements of the physical quantity, these second measurements being measured by the sensors,

    **characterized in that** the processing unit is also configured to, during the execution of the statistical test, carry out the following operations:

    - for each measurement axis, compute a reference value for the first measurements of the sensors, the reference values computed for each measurement axis forming a reference vector,
    - for each sensor, compute a distance representative of the discrepancy between the first measurement vector of this sensor and the computed reference vector, this distance depending on:

        • the discrepancy between the norms of the first measurement vector and of the reference vector, and
        • the angular discrepancy between the first measurement vector and the reference vector,

    - verify that the computed distances meet a preset condition and detect the presence of at least one aberrant measurement if the computed distances meet this preset condition and, conversely, when the computed distances do not meet this preset condition, establish the absence of at least one aberrant measurement.

9. System comprising:

    - a sensor array comprising at least four sensors, the sensors being mechanically joined together and being configured to measure the same physical quantity along at least two non-collinear measurement axes, and
    - a processing unit (30),

**characterized in that** the processing unit (30) is according to Claim 8.

10. System according to Claim 9, wherein each sensor is chosen from the group consisting of a magnetometer, a pressure sensor, a force sensor, an accelerometer and a gyrometer.

11. System according to Claim 9, wherein each sensor comprises at least a first measurement axis and a second measurement axis, the first measurement axes being parallel to one another and the second measurement axes being parallel to one another.

12. System according to Claim 9, wherein each sensor is a three-axis magnetometer or a two-axis pressure sensor.

13. System according to Claim 12, wherein:

- the system comprises at least one permanent magnet (15) able to be fastened with no degree of freedom to a pencil,
- each sensor of the sensor array is able to measure the amplitude of the magnetic field along at least three non-collinear measurement axes,
- the processing unit (30) is able to sense the trace drawn by the pencil on a writing surface, the processing unit (30) being configured, to this end, to locate the permanent magnet fastened to the pencil and to deduce, from the location of the permanent magnet, the position of the tip (8) of the pencil.

Fig. 1

Fig. 2

Fig. 4

Fig. 3

Fig. 5

## RÉFÉRENCES CITÉES DANS LA DESCRIPTION

**Documents brevets cités dans la description**

- US 2008158174 A1
- US 2017350723 A1
- WO 2013144338 A1
- WO 2013144338 A
- WO 2014135421 A
- WO 2014079740 A
- WO 2014180796 A
- US 20100162832 A1